(19) Europäisches Patentamt / European Patent Office / Office européen des brevets

(11) **EP 3 786 905 A1**

(12) **EUROPEAN PATENT APPLICATION**

(43) Date of publication:
**03.03.2021 Bulletin 2021/09**

(51) Int Cl.:
*G07C 7/00* (2006.01)
*H01M 10/63* (2014.01)
*H01M 10/48* (2006.01)
*H01M 10/625* (2014.01)
*H01M 10/42* (2006.01)

(21) Application number: **19194989.0**

(22) Date of filing: **02.09.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Valeo Comfort and Driving Assistance 94046 Créteil Cedex (FR)**

(72) Inventors:
• KLEIN, Patrick
  **94046 Créteil CEDEX (FR)**
• ZLOBIN, Nikolaj
  **94046 Créteil CEDEX (FR)**
• PFAFF, Simon
  **94046 Créteil CEDEX (FR)**

(74) Representative: Delaval, Guillaume Laurent
**VALEO Comfort and Driving Assistance**
**76, rue Auguste Perret**
**Z.I. Europarc**
**94046 Créteil Cedex (FR)**

(54) **VEHICLE TELECOMMUNICATING UNIT AND BACKUP BATTERY FOR VEHICLE TELEMATICS SYSTEM**

(57) The disclosure notably relates to a vehicle telecommunicating unit (1), a backup battery (2) for the same and a vehicle telematics system (3) comprising the sames. The vehicle telecommunicating unit comprises: a first wire connection port (11); a second wire connection port (12); and a circuit system configured to perform functions of: sensing a temperature of a backup battery via the first wire connection port, coding the backup battery via the second wire connection port, and measuring a voltage of the backup battery via the first and the second wire connection ports.

FIG. 1

## Description

## TECHNICAL FIELD

The disclosure relates to the field of vehicle telematics systems, and more specifically to a vehicle telecommunicating unit and to a backup battery for such a vehicle telecommunicating unit in a vehicle telematics system.

## BACKGROUND

Vehicles may often comprise a telematic control unit (TCU) or a telematic electronic control unit (telematic ECU) provided on board. Such a TCU is a central component managing numerous functions and communications in a telematics system between a vehicle and external devices or systems, for example vehicle tracking.

The TCU is generally associated to a backup battery, for example to ensure emergency call operation when the main battery of the vehicle is lost during crash.

The TCU performs several functions associated with the backup battery. Such functions comprise diagnosing, temperature sensing, and coding of the backup battery.

The backup battery is diagnosed in order to detect its end of life by measuring the internal battery impedance.

The temperature of the backup battery is sensed to avoid charging the battery in extreme temperatures and to adapt the end of life impedance threshold which is temperature dependent.

Battery coding or battery adaptation is performed to distinguish different battery size and/or suppliers.

In order to perform all these functions, the entire architecture of existing vehicle telematics systems tends to be complicated. For example, in the case of a backup battery external to the TCU and connected thereto, many wire connections each dedicated to one of the functions are required for connecting the backup battery and the TCU. Namely, the respective wires are dedicated to current delivery from the battery to the TCU, voltage measurement, temperature sensing, and coding of the backup battery. Those wires and associated connections tend to become costly. Further, increased weight of a harness which maintains those wires involves increased $CO_2$ consumption.

Within this context, there is still a need for an improved architecture of the vehicle telematics system comprising the backup battery and the TCU.

## SUMMARY

It is therefore provided a vehicle telecommunicating unit comprising a first wire connection port, a second wire connection port, and a circuit system. The circuit system is configured to perform functions of sensing a temperature of a backup battery via the first wire connection port, coding the backup battery via the second wire connection port, and measuring a voltage of the backup battery via the first and the second wire connection ports.

The circuit system may further comprise a control unit configured to perform selection of at least one of the functions.

The vehicle telecommunicating unit may further comprise a processing system configured to receive and process one or more inputs from the circuit system and to output one or more values corresponding to the at least one of the functions.

The processing system may comprise an analog-digital converter configured to receive the one or more inputs.

The control unit may comprise one or more switches configured for performing the selection.

The control unit may further comprise a resistor one end of which being connected to the first wire connection port, and one of the one or more switches is configured to connect another end of the resistor to a reference voltage for sensing the temperature of the backup battery, and to disconnect the other end of the resistor from the reference voltage for measuring the voltage of the backup battery.

The control unit may further comprise a further resistor one end of which being connected to the second wire connection port, and another one of the one or more switches is configured to connect another end of the further resistor to a further reference voltage for coding the backup battery, and to disconnect the other end of the further resistor from the further reference voltage for measuring the voltage of the backup battery.

The control unit may further comprise a further resistor one end of which being connected to the second wire connection port and other end of which being connected to a further reference voltage, and the vehicle telecommunicating unit may further comprise a third wire connection port, the circuit system being configured to perform the function of coding the backup battery via the second and the third wire connection ports.

It is also provided a backup battery for a vehicle telecommunicating unit. The battery comprises a first wire connection port, a second wire connection port, a temperature sensing unit configured to sense a temperature of the backup battery via the first wire connection port, a coding unit configured to code the backup battery via the second wire connection port, and one or more battery cells arranged between the temperature sensing unit and the coding unit. The backup battery is configured for measuring a voltage of the backup battery via the first and second wire connection ports.

The temperature sensing unit may comprise a thermistor.

The coding unit may comprise a resistor.

The backup battery may further comprise a safety circuit connected to one end of the temperature sensing unit or to one end of the coding unit.

It is also provided a vehicle telematics system comprising a vehicle telecommunicating unit according to any one of the preceding examples, and a backup battery according to any one of the preceding examples.

The vehicle telematics system may further comprise a first wire connecting the first wire connection port of the vehicle telecommunicating unit to the first wire connection port of the backup battery, and a second wire connecting the second wire connection port of the vehicle telecommunicating unit to the second wire connection port of the backup battery.

## BRIEF DESCRIPTION OF THE DRAWINGS

Examples of the disclosure will now be described, in a non-limiting manner and in reference to the accompanying drawings, where:

- FIG. 1 shows an example of a vehicle telematics system comprising a vehicle telecommunicating unit and a backup battery; and

- FIG. 2 shows another example of a vehicle telematics system comprising a vehicle telecommunicating unit and a backup battery.

## DETAILED DESCRIPTION

A vehicle telematics system comprises a vehicle telecommunicating unit and a backup battery.

The backup battery ensures emergency operation of the vehicle telecommunicating unit in case of failure or unavailability of a main battery of the vehicle, for example due to a vehicle accident. Indeed, the vehicle telematics system may comprise main wires connected to respectively a positive pole and a negative pole of the backup battery. The main wires may ensure current delivery from the backup battery to the vehicle telecommunicating unit.

The vehicle telecommunicating unit may comprise a global navigation satellite system (GNSS) unit for keeping track of the latitude and longitude values of the vehicle, a cellular modem for the external communication, and an interface such as a microphone or a speaker, for example.

The telecommunicating unit comprises a first wire connection port and a second wire connection port (e.g. in addition to main wire connection ports).

These first and second wire connection ports of the vehicle telecommunicating unit may comprise pins, plugs, or any other wire connecting terminals.

The vehicle telecommunicating unit comprises a circuit system. The circuit system is configured to perform the functions of sensing a temperature of the backup battery via the first wire connection port, coding the backup battery via the second wire connection port, and measuring a voltage of the backup battery via the first and the second wire connection ports.

The circuit system may perform the function of voltage measurement of the backup battery in order to derive the internal battery impedance to diagnose the backup battery.

The circuit system may perform the function of temperature sensing in order to avoid charging the battery in extreme temperature and to adapt the end of life impedance threshold which is temperature dependent.

The circuit system may perform the function of battery coding in order to distinguish different backup battery size and/or suppliers.

The first wire connection port of the vehicle telecommunicating unit is configured to serve not only for the temperature sensing of the backup battery, but also for the voltage measurement of the backup battery. The second wire connection port of the vehicle telecommunicating unit is configured to serve not only for the backup battery coding, but also for the voltage measurement of the backup battery. Therefore, there is no need to have additional wire connections dedicated only to the voltage measurement of the backup battery and the number of wires in total required for connecting the vehicle telecommunicating unit and the backup battery can be effectively reduced. As such, the reduced number of wires in total simplifies the entire architecture of the vehicle telematics system. Further, the presence of fewer wire connections in total decreases the system cost due to wires and associated connections, as well as the total weight of the harness.

The use of the first and second wire connection ports of the vehicle telecommunicating unit as above may enable accurate measurement of the backup battery voltage.

The circuit system may further comprise a control unit configured to perform selection of at least one of the above functions. Such a control unit enables at least one of the above functions to be performed selectively. Thus, the control unit may effectively facilitate the selective performance of the above functions.

The vehicle telecommunicating unit may further comprise a processing system configured to receive and process one or more inputs from the circuit system and to output one or more values corresponding to the at least one of the functions.

Thus, the processing system receives one or more inputs from the circuit system with reference to at least one of the above functions, namely the temperature sensing, coding and voltage measurement of the backup battery, respectively. The processing system further processes those inputs, and outputs one or more values corresponding to the at least one of those functions. In this way, the processing system may effectively facilitate the selective performance of the above functions.

The processing system may comprise, for example a Micro Controller Unit (MCU), a memory, programmable input/output peripherals, or any other components for receiving, processing, and/or outputting functions.

The processing system may comprise an analog-digital converter configured to receive the one or more inputs. Such an analog-digital converter may be integrated inside the processing system, or separated outside from and connected to the processing system.

The analog-digital converter enables any analog inputs from the circuit system to be efficiently converted into digital form to be processed by the processing system, as well as the processed digital outputs to be converted back into analog form, thus facilitating the entire processing of the inputs/outputs.

The control unit of the circuit system may comprise one or more switches configured for performing the selection of the at least one of the above functions. Thus the at least one of the above functions, namely the temperature sensing, coding and voltage measurement of the backup battery, respectively, is selectively performed by controlling the one or more switches. In examples, the one or more switches may control the first wire connection port to be engaged in either temperature sensing or voltage measurement of the backup battery, and the second wire connection port to be engaged in either coding or voltage measurement of the backup battery.

Any such switch may comprise a transistor or a relay, for example. Further, the control unit may comprise any other suitable functioning element or component in place of the switches. By way of example only, the control unit may comprise one or more generators.

Next, the backup battery associated to the vehicle telecommunicating unit is discussed in detail.

The backup battery comprises a first wire connection port and a second wire connection port (e.g. in addition to main wire connection ports).

The backup battery further comprises a temperature sensing unit configured to sense a temperature of the backup battery via the first wire connection port.

The backup battery further comprises a coding unit configured to code the backup battery via the second wire connection port.

The first and second wire connection ports of the backup battery may comprise, for example pins, plugs, or any other connecting terminals.

The backup battery may comprise one or more battery cells arranged between the temperature sensing unit and the coding unit.

That is, the temperature sensing unit and the coding unit are connected respectively to one end of the one or more battery cells, namely either a positive pole or a negative pole of the one or more battery cells.

The voltage of the backup battery is measured via the first wire connection port and the second wire connection port. That is, the first wire connection port of the backup battery may serve not only for the temperature sensing of the backup battery, but also for the voltage measurement of the backup battery. The second wire connection port of the backup battery may serve not only for the backup battery coding, but also for the voltage measurement of the backup battery. Therefore, there is no need to have additional wire connections dedicated only to the voltage measurement and the number of wires in total required for connecting the vehicle telecommunicating unit and the backup battery can be effectively reduced. As such, the reduced number of wires in total simplifies the entire architecture of the vehicle telematics system. Further, the presence of fewer wire connections in total decreases the system cost due to wires and associated connections, as well as the total weight of the harness.

The use of the first and second wire connection ports of the backup battery as above may enable accurate measurement of the backup battery voltage.

The temperature sensing unit may comprise a thermistor. Such a thermistor may comprise a negative temperature coefficient (NTC) thermistor, a positive temperature coefficient (PTC) thermistor, or any other suitable element or sensor for temperature sensing. Such a thermistor may be advantageous for cost effectiveness and high sensitivity.

The coding unit may comprise a resistor. Such a resistor may facilitate a battery coding or battery adaptation.

The backup battery may further comprise a safety circuit. The safety circuit may be connected to either one end of the temperature sensing unit or to one end of the coding unit. The safety circuit is configured to disconnect a circuit of the backup battery. Such a safety circuit may ensure safety operation of the backup battery in case of emergency, and avoid hazard in case of short circuits of battery wires in the harness.

In examples, the safety circuit may be arranged in series with the one or more battery cells. In such examples, either the temperature sensing unit or the coding unit may be connected between the safety circuit and the one or more battery cells, and the other one of the temperature sensing unit or the coding unit may be connected to the other end of the one or more battery cells. In this manner, the temperature sensing unit or the coding unit may convey the voltage of a respective end of the one or more battery cells to respectively the first and second wire connection ports, without addition of the voltage of the safety circuit. This improves measurement of the voltage of the backup battery, since the measurement is not perturbated by the voltage of the safety circuit and its parasitic impedance.

The backup battery may be an external backup battery. In other words, the backup battery may be provided as a component separate from the vehicle telecommunicating unit, and configured to be externally connected to the vehicle telecommunicating unit. In examples, the backup battery may comprise a casing, and the vehicle telecommunicating unit may also comprise a casing. In such examples, the backup battery may be connected to the vehicle telecommunicating unit, for example to form a vehicle telematics system, and the casing of the backup battery may be arranged outside the casing of the vehicle telecommunicating unit.

The present disclosure also provides a vehicle telematics system comprising a vehicle telecommunicating unit according to any one of the aforementioned examples and a backup battery according to any one of the aforementioned examples.

The vehicle telematics system may further comprise a first wire connecting the first wire connection port of the vehicle telecommunicating unit to the first wire connection port of the backup battery, and a second wire connecting the second wire connection port of the vehicle telecommunicating unit to the second wire connection port of the backup battery.

In examples, the vehicle telematics system may further comprise a respective harness each maintaining the first and second wires, and the main wires. The harness may comprise any structure physically maintaining wires together. In specific examples, the only wires maintained by the harness are the first and second wires, or the first and second wires in addition to the main wires.

By way of example only, a length of each of the first wire and the second wire may be higher than 10 cm or 50 cm, and/or lower than 10 m or 5 m, for example of the order of 2 to 3 m.

The vehicle telecommunicating unit, the backup battery and the vehicle telematics system according to the present disclosure may be applied to any type of terrestrial vehicle. Such a vehicle may be an automobile, a bus, a motorbike, or any other terrestrial vehicles.

In this way, the present disclosure lies in the concept that the wire connections for temperature sensing and coding of the backup battery can also serve for measuring the backup battery voltage. Namely, the wire connection for sensing the temperature of the backup battery and the wire connection for coding the backup battery may constitute a circuit for measuring the voltage of the backup battery as well. Those functions can be selectively performed by being controlled via the control unit. Thus, additional wire connections dedicated only to measurement of the backup battery voltage may be omitted and the required number of wires in total may be reduced, resulting in reduced system cost due to wires and associated connections, as well as reduced total weight of the harness. Further, the architecture of the entire telematics system can be simplified.

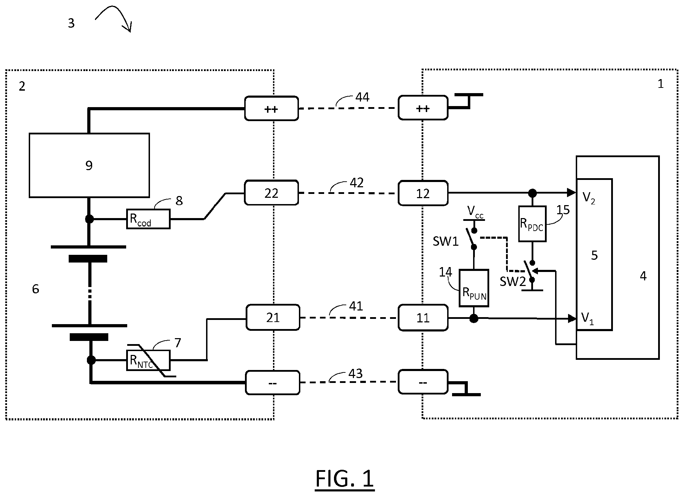

Now, a specific example of the vehicle telematics system is discussed with reference to FIG. 1.

As shown in FIG. 1, a vehicle telematics system 3 comprises a vehicle telecommunicating unit 1 and a backup battery 2. Backup battery 2 may be a battery pack comprising one or more battery cell(s) 6.

Vehicle telematics system 3 comprises a first wire 41 connecting a first wire connection port 11 of vehicle telecommunicating unit 1 to a first wire connection port 21 of backup battery 2, and a second wire 42 connecting a second wire connection port 12 of vehicle telecommunicating unit 1 to a second wire connection port 22 of backup battery 2.

Vehicle telematics system 3 further comprises main wires 43, 44. In FIG. 1, main wire 43 is connected to a negative pole and main wire 44 is connected to a positive pole of one or more battery cell(s) 6. However, main wire 43 may be connected to a positive pole and main wire 44 may be connected to a negative pole of one or more battery cell(s) 6 (not shown in Figures). The main wires 43, 44 serve to supply the vehicle telecommunicating unit 1 from the backup battery 2.

As shown in FIG. 1, vehicle telecommunicating unit 1 comprises a processing system 4 which comprises an analog-digital converter 5.

In the specific example shown in FIG. 1, the control unit of vehicle telecommunicating unit 1 comprises a switch SW1. The control unit further comprises a resistor 14 whose resistance is referred to as $R_{PUN}$. One end of resistor 14 is connected to first wire connection port 11. In this example, switch SW1 is configured to connect another end of resistor 14 to a reference voltage for sensing the temperature of backup battery 2. Switch SW1 is further configured to disconnect said another end of resistor 14 from the reference voltage for measuring the voltage of backup battery 2.

The reference voltage may be a voltage of an existing internal power supply rail, Vcc, for example. $V_{cc}$ may be 3.3V or 5V supply.

As shown in FIG. 1, the one end of resistor 14 which is connected to first wire connection port 11 is further connected to analog-digital converter 5. Thus, as shown in FIG. 1, a voltage of first wire connection port 11 and the one end of resistor 14 is voltage $V_1$ measured at analog-digital converter 5.

The control unit further comprises a further resistor 15 whose resistance is referred to as $R_{PDC}$. One end of further resistor 15 is connected to second wire connection port 12 of vehicle telecommunicating unit 1. Further, another switch SW2 is configured to connect another end of further resistor 15 to a further reference voltage for coding backup battery 2. Another switch SW2 is further configured to disconnect said another end of resistor 15 from the further reference voltage for measuring the voltage of backup battery 2.

The further reference voltage may be a voltage of an existing internal power supply rail, Vcc, for example. More generally it may be the ground.

As shown in FIG. 1, the one end of further resistor 15 which is connected to second wire connection port 12 is further connected to analog-digital converter 5. Thus, a voltage of second wire connection port 12 and the one end of further resistor 15 is voltage $V_2$ measured at analog-digital converter 5.

In the present example shown in FIG. 1, a temperature sensing unit 7 of backup battery 2 is an NTC thermistor connected to first wire connection port 21 of backup battery 2 and the negative pole of one or more battery cells 6.

In the present example shown in FIG. 1, a coding unit 8 of backup battery 2 is a resistor connected to second wire connection port 22 of backup battery 2 and the positive pole of one or more battery cells 6.

Although not shown in Figures, it is to be noted that coding unit 8 may be connected to the negative pole of one or more battery cells 6, in which case temperature sensing unit 7 is to be connected to the positive pole of one or more battery cells 6.

Further, backup battery 2 may comprise a safety circuit 9. In the present example shown in FIG. 1, coding unit 8 is provided between one or more battery cells 6 and safety circuit 9.

In this specific example, the circuit system of vehicle telecommunicating unit 1 controls the selection of the functions: temperature sensing, coding, and voltage measurement of backup battery 2, to be performed via switches SW1, SW2.

Specifically, when both switches SW1, SW2 are opened, processing system 4 determines voltage $V_{BUB}$ of backup battery 2, namely the voltage between the positive pole and the negative pole of one or more battery cells 6 as follows:

$$V_{BUB} = V_2 - V_1$$

When switch SW1 is closed, processing system 4 determines resistance $R_{NTC}$ of temperature sensing unit 7 as follows:

$$R_{NTC} = V_1 \times R_{PUN} / (V_{cc} - V_1)$$

When switch SW2 is closed, processing system 4 determines resistance $R_{COD}$ of coding unit 8 as follows:

$$R_{COD} = R_{PDC} \times (V_2{}^* - V_2) / V_2$$

$V_2{}^* = V_2$ value measured when SW2 is opened.

In this way, first wire 41 connecting first wire connection port 11 of vehicle telecommunicating unit 1 and first wire connection port 21 of backup battery 2 may serve either for sensing the temperature of backup battery 2 (SW1 closed) or for measuring the precise voltage of one pole of backup battery 2 (SW1 opened). Second wire 42 connecting second wire connection port 12 of vehicle telecommunicating unit 1 and second wire connection port 22 of backup battery 2 may serve either for performing backup battery coding (SW 2 closed) or for measuring the precise voltage of another pole of backup battery 2 (SW2 opened). Thus, the voltage of backup battery 2 can be precisely measured via first and second wires 41, 42, and eventually the internal impedance of backup battery 2 can be precisely measured.

Thus, the circuit system of vehicle telecommunicating unit 1 comprises switches SW1, SW2, and resistors 14, 15, which collectively perform functions of temperature sensing, coding and voltage measuring of backup battery 2 via first and second wire connection ports 11, 12 selectively.

Although not shown in Figures, it is to be noted that vehicle telematics system 3 may comprise any other additional or peripheral elements as necessary. By way of example only, vehicle telematics system 3 may comprise one or more additional switches to prevent leakage current discharging the battery (not shown in Figures).

As such, the entire architecture of vehicle telematics system 3 can be simplified and the number of wires in total connecting vehicle telecommunicating unit 1 and backup battery 2 can be effectively reduced. Specifically, in the specific example illustrated in FIG. 1, there are only four wires in total connecting vehicle telecommunicating unit 1 and backup battery 2. Thus, the system cost due to wires and associated connections can be decreased, and the total weight of the harness can be reduced.

Further, the use of first and second wires 41, 42 as above may enable accurate measurement of the voltage of backup battery 2 with relatively less impact from parasitic impedances.

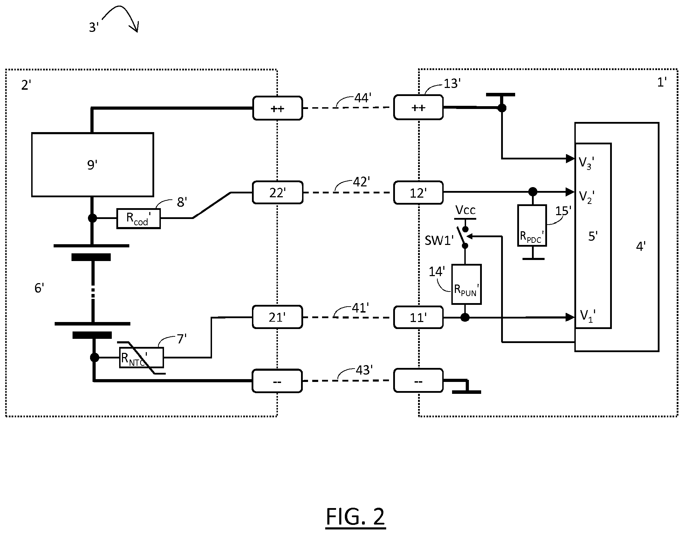

Now, another specific example of the vehicle telematics system is discussed with reference to FIG. 2.

As shown in FIG. 2, a vehicle telematics system 3' comprises a vehicle telecommunicating unit 1' and a backup battery 2'. Backup battery 2' may be a battery pack comprising one or more battery cell(s) 6'.

Vehicle telematics system 3' comprises a first wire 41' connecting a first wire connection port 11' of vehicle telecommunicating unit 1' to a first wire connection port 21' of backup battery 2', and a second wire 42' connecting a second wire connection port 12' of vehicle telecommunicating unit 1' to a second wire connection port 22' of backup battery 2'.

Vehicle telematics system 3' further comprises main wires 43', 44'. In FIG. 2, main wire 43' is connected to a negative pole and main wire 44' is connected to a positive pole of one or more battery cell(s) 6'. However, main wire 43' may be connected to a positive pole and main wire 44' may be connected to a negative pole of one or more battery cell(s) 6' (not shown in Figures).

As shown in FIG. 2, vehicle telecommunicating unit 1' comprises a processing system 4' which comprises an analog-digital converter 5'.

In the specific example shown in FIG. 2, the control unit of vehicle telecommunicating unit 1' comprises a switch SW1' and a resistor 14' as similar to those in FIG. 1, thus further details of switch SW1' and resistor 14' are omitted.

In the present example shown in FIG. 2, the control unit further comprise a further resistor 15' whose resistance is referred to as $R_{PDC}'$. One end of further resistor 15' is connected to second wire connection port 12'. In contrast to the aforementioned example shown in FIG. 1, another end of further resistor 15' is connected to a further reference voltage. As with the aforementioned example shown in FIG. 1, such a further reference voltage may be a voltage of an existing internal power supply rail, Vcc, for example. More generally, the reference voltage may be the ground.

As shown in FIG. 2, a voltage of first wire connection port 11' of vehicle telecommunicating unit 1' and the one end of resistor 14' is voltage $V_1$' measured at analog-digital converter 5', and a voltage of second wire connection port 12' of vehicle telecommunicating unit 1' and the one end of further resistor 15' is voltage $V_2$' measured at analog-digital converter 5'.

Further, in the present example shown in FIG. 2, vehicle telecommunicating unit 1' comprises a third wire connection port 13'. Third wire connection port 13' is connected to analog-digital converter 5', thus a voltage of third wire connection port 13' is voltage $V_3$' measured at analog-digital converter 5'. In FIG. 2, main wire 44' connects the third wire connection port 13' to a corresponding port of backup battery 2'.

As with the aforementioned example shown in FIG. 1, a temperature sensing unit 7' and a coding unit 8' of backup battery 2' may be a NTC thermistor and a resistor, respectively. Thus further details of temperature sensing unit 7' and coding unit 8' are omitted.

Further, backup battery 2' may comprise a safety circuit 9'. In the present example shown in FIG. 2, coding unit 8' is provided between one or more battery cells 6' and safety circuit 9'.

In this specific example, the circuit system of vehicle telecommunicating unit 1' performs the function of coding backup battery 2' via second and third wire connection ports 12', 13'. That is, third wire connection port 13' of vehicle telecommunicating unit 1' serves for performing the coding of backup battery 2'.

Namely, the circuit system of vehicle telecommunicating unit 1' controls the selection of the functions, temperature sensing, coding, and voltage measurement of the backup battery 2', to be performed via switch SW1'.

Specifically, when switch SW1' is opened, processing system 4' determines voltage $V_{BUB}$' of backup battery 2', namely the voltage between the positive pole and the negative pole of one or more battery cells 6' as follows:

$$V_{BUB}' = V_2' \times (R_{PDC}' + R_{COD}') / R_{PDC}' - V_1'$$

When switch SW1' is closed, processing system 4' determines resistance $R_{NTC}$' of temperature sensing unit 7' as follows:

$$R_{NTC}' = V_1' \times R_{PUN}' / (V_{cc}' - V_1')$$

Processing system 4' determines resistance $R_{COD}$' of coding unit 8' as follows:

$$R_{COD}' = R_{PDC}' \times (V_3' - V_2') / V_2'$$

In this way, first wire 41' connecting first connection port 11' of vehicle telecommunicating unit 1' and first wire connection port 21' of backup battery 2' may serve either for sensing the temperature of backup battery 2' (SW1' closed) or for measuring the precise voltage of one pole of backup battery 2' (SW1' opened). Second wire 42' connecting second wire connection port 12' of vehicle telecommunicating unit 1' and second wire connection port 22' of backup battery 2' may serve either for performing backup battery coding (SW1' closed) or for measuring the precise voltage of another pole of backup battery 2' (SW1' opened). Thus, the voltage of backup battery 2' can be precisely measured via first and second wires 41', 42', and eventually the internal impedance of backup battery 2' can be precisely measured.

Thus, the circuit system of vehicle telecommunicating unit 1' comprises switch SW1', resistors 14', 15' and third wire connection port 13', which collectively perform functions of temperature sensing, coding and voltage measuring of backup battery 2' via first, second and third wire connection ports 11', 12', 13' selectively.

Although not shown in Figures, it is to be noted that vehicle telematics system 3' may comprise any other additional or peripheral elements as necessary. By way of example only, vehicle telematics system 3' may comprise one or more additional switches to prevent leakage current discharging the battery (not shown in Figures).

As such, the entire architecture of vehicle telematics system 3' can be simplified and the number of wires in total connecting vehicle telecommunicating unit 1' and backup battery 2' can be effectively reduced. Specifically, in the specific example illustrated in FIG. 2, there are only four wires in total connecting vehicle telecommunicating unit 1' and backup battery 2'. Thus, the system cost due to wires and associated connections can be decreased, and the total weight of the harness can be reduced.

Further, the use of first and second wires 41', 42' as above may enable accurate measurement of the voltage of backup battery 2' with relatively less impact from parasitic impedances.

**Claims**

1. A vehicle telecommunicating unit (1, 1') comprising:

a first wire connection port (11, 11');
a second wire connection port (12, 12'); and
a circuit system configured to perform functions of:

sensing a temperature of a backup battery (2, 2') via the first wire connection port (11, 11'),

coding the backup battery (2, 2') via the second wire connection port (12, 12'), and measuring a voltage of the backup battery (2, 2') via the first wire connection port (11, 11') and the second wire connection port (12, 12').

2. The vehicle telecommunicating unit (1, 1') according to claim 1, wherein the circuit system further comprises a control unit configured to perform selection of at least one of the functions.

3. The vehicle telecommunicating unit (1, 1') according to claim 2, further comprising a processing system (4, 4') configured to receive and process one or more inputs from the circuit system and to output one or more values corresponding to the at least one of the functions.

4. The vehicle telecommunicating unit (1, 1') according to claim 3, wherein the processing system (4, 4') comprises an analog-digital converter (5, 5') configured to receive the one or more inputs.

5. The vehicle telecommunicating unit (1, 1') according to any one of claims 2 to 4, wherein the control unit comprises one or more switches configured for performing the selection.

6. The vehicle telecommunicating unit (1, 1') according to claim 5, wherein:

the control unit further comprises a resistor (14, 14') one end of which being connected to the first wire connection port (11, 11'), and one of the one or more switches (SW1, SW1') is configured to connect another end of the resistor (14, 14') to a reference voltage for sensing the temperature of the backup battery (2, 2'), and to disconnect the other end of the resistor (14, 14') from the reference voltage for measuring the voltage of the backup battery (2, 2').

7. The vehicle telecommunicating unit (1) according to claim 6, wherein:

the control unit further comprises a further resistor (15) one end of which being connected to the second wire connection port (12), and another one of the one or more switches (SW2) is configured to connect another end of the further resistor (15) to a further reference voltage for coding the backup battery (2), and to disconnect the other end of the further resistor (15) from the further reference voltage for measuring the voltage of the backup battery (2).

8. The vehicle telecommunicating unit (1') according to claim 6, wherein:

the control unit further comprises a further resistor (15') one end of which being connected to the second wire connection port (12') and other end of which being connected to a further reference voltage, and the vehicle telecommunicating unit (1') further comprises a third wire connection port (13'), the circuit system (1') being configured to perform the function of coding the backup battery (2') via the second wire connection port (12') and the third wire connection port (13').

9. A backup battery (2, 2') for a vehicle telecommunicating unit (1, 1'), comprising:

a first wire connection port (21, 21');
a second wire connection port (22, 22');
a temperature sensing unit (7, 7') configured to sense a temperature of the backup battery (2, 2') via the first wire connection port (21, 21');
a coding unit (8, 8') configured to code the backup battery (2, 2') via the second wire connection port (22, 22'); and
one or more battery cells (6, 6') arranged between the temperature sensing unit (7, 7') and the coding unit (8, 8');
the backup battery (2, 2') being configured for measuring a voltage of the backup battery (2, 2') via the first wire connection port (21, 21') and the second wire connection port (22, 22').

10. The backup battery (2, 2') according to claim 9, wherein the temperature sensing unit (7, 7') comprises a thermistor.

11. The backup battery (2, 2') according to claim 9 or 10, wherein the coding unit (8, 8') comprises a resistor.

12. The backup battery (2, 2') according to any one of claims 9 to 11, further comprising a safety circuit (9, 9') connected to one end of the temperature sensing unit (7, 7') or to one end of the coding unit (8, 8').

13. A vehicle telematics system (3, 3') comprising:

a vehicle telecommunicating unit (1, 1') according to any one of claims 1 to 8; and
a backup battery (2, 2') according to any one of claims 9 to 12.

14. The vehicle telematics system (3, 3') according to claim 13, further comprising:

a first wire (41, 41') connecting the first wire connection port (11, 11') of the vehicle telecommunicating unit (1, 1') to the first wire connection port (21, 21') of the backup battery (2, 2'); and a second wire (42, 42') connecting the second wire connection port (12, 12') of the vehicle telecommunicating unit (1, 1') to the second wire connection port (22, 22') of the backup battery (2, 2').

## FIG. 1

FIG. 2

Europäisches
Patentamt

European
Patent Office

Office européen
des brevets

# EUROPEAN SEARCH REPORT

Application Number

EP 19 19 4989

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 218 805 B1 (MELCHER DOMENIC [CH]) 17 April 2001 (2001-04-17) <br> * paragraph [0057] * <br> * paragraph [0075] * <br> * paragraph [0087] - paragraph [0092] * <br> * figures 8,9 * <br> ----- | 1-14 | INV. <br> G07C7/00 <br> H01M10/625 <br> H01M10/63 <br><br> ADD. <br> H01M10/42 <br> H01M10/48 |
| X | EP 1 807 710 A1 (LEM LIAISONS ELECTRON MEC [CH]) 18 July 2007 (2007-07-18) <br> * column 2 - column 3 * <br> * figures 2,3 * <br> ----- | 1-14 | |
| A | WO 2012/134624 A1 (CONTINENTAL AUTOMOTIVE SYSTEMS [US]; ALMQUIST EDWARD [US] ET AL.) 4 October 2012 (2012-10-04) <br> * paragraph [0001] - paragraph [0007] * <br> ----- | 1,13 | |

TECHNICAL FIELDS
SEARCHED      (IPC)

G01R
G07C
H01M

The present search report has been drawn up for all claims

| Place of search | Date of completion of the search | Examiner |
|---|---|---|
| The Hague | 19 February 2020 | Mechenbier, Bernd |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

&  : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 19 19 4989

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2020

| Patent document cited in search report | | | Publication date | Patent family member(s) | | | Publication date |
|---|---|---|---|---|---|---|---|
| US 6218805 | | B1 | 17-04-2001 | AT | 329275 | T | 15-06-2006 |
| | | | | CA | 2292658 | A1 | 28-10-1999 |
| | | | | CN | 1263600 | A | 16-08-2000 |
| | | | | DK | 0990167 | T3 | 18-09-2006 |
| | | | | EP | 0990167 | A1 | 05-04-2000 |
| | | | | ES | 2267244 | T3 | 01-03-2007 |
| | | | | JP | 2001502436 | A | 20-02-2001 |
| | | | | PT | 990167 | E | 31-10-2006 |
| | | | | US | 6218805 | B1 | 17-04-2001 |
| | | | | WO | 9954744 | A1 | 28-10-1999 |
| EP 1807710 | | A1 | 18-07-2007 | AT | 456059 | T | 15-02-2010 |
| | | | | CN | 101048670 | A | 03-10-2007 |
| | | | | EP | 1807710 | A1 | 18-07-2007 |
| | | | | JP | 2008519253 | A | 05-06-2008 |
| | | | | US | 2008094068 | A1 | 24-04-2008 |
| | | | | WO | 2006048625 | A1 | 11-05-2006 |
| WO 2012134624 | | A1 | 04-10-2012 | CN | 103563161 | A | 05-02-2014 |
| | | | | DE | 112012001516 | T5 | 24-12-2013 |
| | | | | US | 2012249284 | A1 | 04-10-2012 |
| | | | | WO | 2012134624 | A1 | 04-10-2012 |

EPO FORM P0459

For more details about this annex : see Official Journal of the European Patent Office, No. 12/82